(19) Europäisches Patentamt
European Patent Office
Office européen des brevets

(11) **EP 2 759 813 B1**

(12) **EUROPÄISCHE PATENTSCHRIFT**

(45) Veröffentlichungstag und Bekanntmachung des Hinweises auf die Patenterteilung:
**13.04.2016 Patentblatt 2016/15**

(21) Anmeldenummer: **13152618.8**

(22) Anmeldetag: **25.01.2013**

(51) Int Cl.:
*G01F 23/284* *(2006.01)*          *G01B 7/26* *(2006.01)*
*G01R 27/28* *(2006.01)*

(54) **Verfahren und Sensor zur Füllstandsmessung geschichteter Medien**

Method and sensor for measuring the fill level of layered media

Procédé et capteur de mesure du niveau de remplissage de supports stratifiés

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**30.07.2014 Patentblatt 2014/31**

(73) Patentinhaber: **SICK AG**
**79183 Waldkirch (DE)**

(72) Erfinder:
• **Weber, Thomas**
**77960 Seelbach (DE)**

• **Schweiger, Stefan**
**77704 Oberkirch (DE)**

(74) Vertreter: **Hehl, Ulrich**
**SICK AG**
**Intellectual Property**
**Erwin-Sick-Strasse 1**
**79183 Waldkirch (DE)**

(56) Entgegenhaltungen:
**EP-A1- 0 871 019       EP-A1- 2 365 302**
**WO-A1-98/19139        DE-A1- 10 044 888**
**DE-A1- 10 249 544      DE-A1-102005 063 079**

**Beschreibung**

Die Erfindung betrifft ein Verfahren zur Füllstandsmessung in einem Behälter mit einem ersten Medium und mindestens einem darüber angeordneten zweiten Medium, insbesondere einer Schaumschicht, nach dem Oberbegriff von Anspruch 1 sowie einen für dieses Verfahren ausgebildeten Sensor.

Ein bekanntes Verfahren zur Füllstandsmessung beruht darauf, ein elektromagnetisches Signal in den Behälter mit dem zu vermessenden Füllstand zu senden und das reflektierte Signal auszuwerten. Eine Möglichkeit ist, das Signal frei abzustrahlen, wie dies beim Radar geschieht. Wegen der unkontrollierten Wellenausbreitung wird häufig das Verfahren der Zeitbereichsreflektometrie (TDR, Time Domain Reflectometry) bevorzugt. Es basiert auf der Bestimmung von Laufzeiten eines elektromagnetischen Signals, um den Abstand einer Diskontinuität des Leitungswellenwiderstandes zu ermitteln. Der Unterschied zum Radar besteht darin, dass die elektromagnetischen Wellen nicht ins Freie abgestrahlt, sondern entlang eines Leiters geführt werden. Der Leiter ist als Monosonde oder Koaxialsonde ausgebildet, welche senkrecht oder schräg in den Tank eingeführt wird und möglichst dicht bis zum Boden reicht, um den vollen Messbereich abzudecken.

Bei einer TDR-Messung wird ein sehr kurzer elektrischer Sendeimpuls in den Leiter eingespeist und durchläuft ihn in Richtung des gegenüberliegenden Endes. Trifft der Impuls auf eine Störstelle, was gleichbedeutend mit einer Änderung des örtlichen Wellenwiderstands ist, wird ein Teil der Sendeenergie zum Leitungseingang zurückreflektiert. Aus der Laufzeit zwischen dem Aussenden des Sendeimpulses und dem Empfang der Reflexion lässt sich die Position der Störstelle ortsgenau errechnen. Ein wichtiges Beispiel einer Störstelle ist eine Grenzfläche, welche zwei räumliche Bereiche mit unterschiedlichen physikalischen oder chemischen Eigenschaften trennt, wie eine Grenzfläche zwischen zwei Medien.

Um den Empfangszeitpunkt genau bestimmen zu können, wird der Verlauf des Empfangssignals abgetastet und einer digitalen Auswertung zugeführt. Dabei werden beispielsweise lokale Extremstellen im Signalverlauf gesucht und deren zeitliche Lage einer Reflexion an einer Grenzfläche zugeordnet.

Schwierigkeiten entstehen, wenn mehrere Grenzflächen vorhanden sind, wie dies beispielsweise bei mehreren Medien in einem Behälter der Fall ist. Dabei kann es sich um Wasser handeln, das sich am Boden eines Öltanks ansammelt. Ein wichtiger Fall ist Schaumbildung an der Oberfläche einer Flüssigkeit. Hier möchte man häufig den Füllstand des eigentlichen Mediums ermitteln. Eine Reflexion an der Grenzfläche zum Schaum kann aber mit dem Messpuls des Mediums verwechselt werden oder sogar in einer Weise mit diesem Messpuls verschmelzen, dass gar kein sinnvolles Messergebnis mehr geliefert wird. Ein herkömmlicher Auswertealgorithmus, der nur für die Erkennung einzelner Reflexionssignale ausgelegt ist, kann also mit solchen Messsituationen nicht umgehen.

Selbst einer Erweiterung eines herkömmlichen Auswertealgorithmus' um eine Mehrechoauflösung von mehreren Grenzschichten steht somit die in der Praxis oft nicht gegebene Voraussetzung im Wege, dass die Trennschichten einen bestimmten Abstand aufweisen müssen, damit die aus den Trennschichten resultierenden Pulse im Echosignal einen hinreichenden Abstand voneinander haben. Noch schwieriger wird es, wenn die einzelnen Schichten der Medien nicht einmal in sich homogen sind. Beispielsweise kann bei Schaum die Dichte und damit die relative Dielektrizitätskonstante nach einer unbekannten, meist monotonen Funktion ansteigen, so dass sich zahlreiche kleine, einander überlagernde Pulse im Echosignal ergeben.

Ein möglicher Ausweg könnte darin bestehen, die Bandbreite des Sendepulses zu erhöhen. Dadurch sind Echopulse, die durch nahe beieinander liegende Grenzschichten entstehen, eher getrennt. Gleichzeitig verschärfen sich aber auch die Anforderungen an das Elektronikdesign, etwa die Abtastrate sowie die nachfolgende Signalerfassung. Zudem nimmt bei sehr hohen Frequenzen jenseits von 10GHz die Dämpfung in einer Monosonde durch den Skin-Effekt stark zu, so dass das Signal-Rausch-Verhältnis unzureichend werden kann. In jedem Fall löst eine Bandbreitenerhöhung noch nicht das Problem, die an Schaum und Medium entstehenden Echos zu unterscheiden und so sicherzustellen, dass nicht der Schaumstand als Füllstand des Mediums, ein verfälschter Füllstand des Mediums oder im schlechtesten Fall gar kein Messwert ausgegeben wird.

Ein anderer Ausweg könnte darin liegen, anstelle einer Monosonde eine Koaxialsonde zu verwenden. Dadurch kann die Resistenz gegenüber Schaum verbessert werden, denn die Echos werden hauptsächlich durch Variationen im Feldraum innerhalb des Koaxialrohrs hervorgerufen. Durch eine vorteilhafte Ausgestaltung des Koaxialrohrs mit nur kleinen Öffnungen ist es möglich, das Eindringen von Schaum in das Rohr zu minimieren. Allerdings werden so auch gegenüber einer Monosonde die Einsatzmöglichkeiten beschränkt, da sich Anteile des zu messenden Mediums im Koaxialrohr ablagern können. Dies kann die Verfügbarkeit des Sensors beeinträchtigen. In Anwendungen mit Hygieneanforderungen ist der Einsatz gar nicht möglich. Außerdem kann auf diese Weise der Füllstand des Schaums selbst nicht bestimmt werden.

Der Ansatz, die Schaumbildung von vorneherein durch den Zusatz von chemischen Mitteln oder durch den Betrieb der Anlage mit optimierten Prozessparametern zu reduzieren, ist in den meisten Anwendungen nicht umsetzbar. Chemische Mittel beeinflussen das Prozessmedium und sind im Lebensmittelbereich ohnehin meist undenkbar. Durch optimierte Prozessparameter lässt sich das Problem mildern, gerade in der Betriebsphase beim Anfahren kann eine Schaumbildung aber auf diese Weise selten ausreichend unterdrückt werden.

Die EP 2 365 302 A1 beschreibt ein Verfahren, bei dem der Abstand zu einer Grenzfläche und die relative Dielektrizitätskonstante des die Grenzfläche erzeugenden Mediums ein erstes Mal anhand eines Übergangspulses am Übergang der Sonde in den Behälter und des Echos an der Grenzfläche und ein zweites Mal anhand eines Artefaktpulses vom Ende der Sonde bestimmt wird. Sind diese Messungen nicht zueinander konsistent, so wird auf die Anwesenheit einer weiteren Grenzschicht geschlossen und das Verfahren iterativ auf die weitere Grenzschicht angewandt, bis alle Füllstände vermessen sind. Dies erfordert genaue Informationen der beiden Referenzpulse, also des Übergangspulses vom Anfang und des Artefaktpulses vom Ende der Sonde. Um hier eine ausreichende Genauigkeit zu erzielen, werden hohe Anforderungen an die Elektronik gestellt, die zu entsprechenden Herstellkosten führen. Selbst damit lässt sich aus dem Übergangspuls einer Monosonde, die anders als eine Koaxialsonde sehr vielen Störeffekten ausgesetzt ist, nicht hinreichend genau auf den transmittierten Anteil der Sendeenergie schließen. Zudem ist der Artefaktpuls am Ende der Sonde durch die Ausbreitung in den unterschiedlichen Medien in einer zunächst völlig undefinierten Weise verzögert und abgeschwächt und steht daher in vielen Messsituationen nicht als zuverlässige Referenz zur Verfügung. Außerdem kann bei niedrigen Füllständen auch der Artefaktpuls von Messpulsen überlagert sein, so dass die Referenz sogar verfälscht ist.

Die DE 100 51 151 A1 zeigt ein TDR-Verfahren zur Bestimmung der Positionen oberer und unterer Grenzflächen einer ersten Flüssigkeit, die auf einer zweiten Flüssigkeit eines Behälters schwimmt. Es wird aber nicht genauer erklärt, wie die entsprechenden Echos an den beiden Grenzflächen erkannt und unterschieden werden. Außerdem basiert auch hier die Auswertung auf dem Artefaktpuls, der in der DE 100 51 151 A1 als Bezugsrückführimpuls bezeichnet ist. Das hat die oben geschilderten erheblichen Nachteile.

Aus der US 6,724,197 B2 ist ein Füllstandssensor bekannt, mit dem der Füllstand des unteren von zwei aufeinander geschichteten Medien bestimmbar ist. Dazu ist aber eine besondere und aufwändige Sondenform erforderlich.

Die US 5,723,979 A offenbart einen TDR-Füllstandssensor zur Messung in Flüssigkeitsmischungen. Beschrieben wird lediglich eine Sondenform. Ein Auswertungsverfahren, erst recht eine Bestimmung der Entfernung zu mehreren Grenzschichten, ist nicht beschrieben.

In der US 6,445,192 B1 werden Zwillingspulse an doppelten Grenzflächen von einem TDR-Sensor anhand des Steigungsverhaltens der Signalform aufgetrennt. Allerdings wird nicht erklärt, wie damit der Füllstand eines unter einer Störschicht liegenden Mediums vermessen wird.

Aus der DE 101 96 640 T1 ist eine verbesserte Schwellwerteinstellung für einen Radar-Pegeltransmitter bekannt, der unter Verwendung eines TDR-Verfahrens zum Messen von Füllständen mehrerer Materialien in Speicherbehältern eingesetzt wird. Dabei werden mehrere, jeweils mit einer spezifischen Materialgrenzfläche in Beziehung stehende Schwellenwerte verwendet, um die Pegel der verschiedenen Materialien zu erfassen.

In der DE 100 44 888 A1 werden die dielektrischen Konstanten und Schichtdicken sich überlagernder Füllgüter aus dem Amplitudenverhältnis einer Echokurve eines Pulsradars bestimmt.

Die nachveröffentlichte DE 10 2012 101 725 identifiziert in einem Signalverlauf eines TDR-Füllstandssensors anhand von Amplitudenerwartungswerten einen ersten Messpuls und einen zweiten Messpuls, die an einer Grenzfläche zu dem zu vermessenden Medium beziehungsweise einer darüber befindlichen Stör- oder Schaumschicht entstehen. Die Erwartungswerte werden insbesondere aus einer bekannten relativen Dielektrizitätskonstanten des Mediums und einer Referenzamplitude eines bei leerem Behälter am Sondenende entstehenden Artefaktpulses berechnet.

Die DE 10 2005 063 079 A1 offenbart ein Verfahren zur Ermittlung und Überwachung eines Füllstands eines Mediums in einem Behälter. Dabei wird ein Mikrowellensignal in den Behälter gestrahlt und die resultierende Echofunktion ausgewertet. Das Verfahren ist dafür gedacht und geeignet, eine unebene Mediumsoberfläche beispielsweise durch Schüttkegelbildung zu verarbeiten, wo in der Echofunktion aufgrund der Unebenheiten gleich mehrere Nutzechosignale entstehen. Es wird dann ein Gruppenbereich der Nutzechosignale identifiziert und die Messposition als Flächenschwerpunkt des Gruppenbereichs bestimmt. Dies soll eine mittlere Füllhöhe repräsentieren.

In der DE 102 49 544 A1 wird ein weiteres Verfahren zur Füllstandsmessung nach dem Laufzeitprinzip beschrieben. Um Überlagerungen eines ersten Echopulses von dem Füllgut mit einem zweiten Echopuls von einem Störer zu berücksichtigen, werden Laufzeiten zu einem Punkt X auf der steigenden Flanke, zu dem Maximum M der Überlagerung und zu einem Punkt Y auf der fallenden Flanke bestimmt. Die Laufzeit zur Füllgutoberfläche wird aus diesen Laufzeiten in diversen Ausführungsformen auf verschiedene Weise abgeleitet. Eine Ausführungsform sieht einen Formfaktor zur Korrektur von Asymmetrien der Überlagerung vor, welcher das Integral der Echokurve von dem Punkt X zu dem Maximum M mit dem Integral von dem Maximum M zu dem Punkt Y vergleicht.

Soweit demnach im Stand der Technik überhaupt die Möglichkeit gegeben wird, mehrere Grenzschichten aufzulösen, so basieren alle diese Verfahren darauf, Pulse an den Grenzschichten zu erkennen. An dünnen Schichten und vor allem Schaum, der sich in sehr unterschiedlicher Weise ausbilden und eine Vielzahl ineinanderlaufender Pulse erzeugen kann, scheitert aber die Erkennung einzelner Pulse. Das Ergebnis sind große Messfehler oder, wenn in dem aufgezeichneten Signal eine Vielzahl Pulse zur Unkenntlichkeit miteinander verschmolzen ist und daher kein Messpuls mehr erkannt wird, sogar Fehlerzustände des Sensors. TDR-Sensoren sind deshalb herkömmlich für die Schaummessung nicht einsetzbar.

Es ist daher Aufgabe der Erfindung, die Füllstandsmessung in einem Behälter mit mehreren Schichten zu verbessern.

Diese Aufgabe wird durch ein Verfahren zur Füllstandsmessung in einem Behälter mit einem ersten Medium und mindestens einem darüber angeordneten zweiten Medium nach Anspruch 1 sowie einen für dieses Verfahren ausgebildeten Sensor nach Anspruch 15 gelöst. Dabei geht die Erfindung von dem Grundgedanken aus, den Signalverlauf eines in dem Behälter reflektierten Signals nicht nur an der Stelle auszuwerten, wo ein Grenzübergang lokalisiert wird, sondern den Signalverlauf von einer Referenzposition der Sonde an aufzuintegrieren. Dabei entsteht ein aufintegrierter Signalverlauf, der selbst eine Funktion derjenigen Sondenposition ist, bis zu der jeweils integriert wurde, beziehungsweise eine Funktion der mit der Sondenposition monoton zusammenhängenden Zeit. Es wird so gleichsam die Historie der vor dem Grenzübergang reflektierten Signalanteile mit berücksichtigt.

Der Signalverlauf ist vorzugsweise eine diskret abgetastete Zeitreihe von Amplitudenwerten der Empfangsintensität des in dem Behälter reflektierten Sendesignals, beispielsweise eines Mikrowellensignals. Unter Aufintegrieren wird hier das Bilden eines summarischen Maßes für den Signalverlauf bis zu einem Betrachtungspunkt verstanden. Dazu werden im einfachsten Fall die diskreten Abtastwerte aufsummiert. Dies entspricht einer Näherung des Integrals durch eine Stufenfunktion. Genauere Integrationsverfahren, wie das Trapezverfahren oder das Runge-Kutta-Verfahren, sind aber ebenso denkbar.

Die Erfindung hat den Vorteil, dass eine Messung bis zur Oberfläche eines bestimmten Mediums auch dann ermöglicht wird, wenn weitere Medien oder Störschichten wie Schaum darüber liegen. Durch das Aufintegrieren gelingt dies gänzlich unabhängig von der konkreten Kurvenform und insbesondere davon, wie gut sich Pulse in dem Signalverlauf identifizieren lassen. Ebenso wenig werden einzelne Amplitudenwerte des Signalverlaufs mit Schwellen oder Ähnlichem verglichen, wo es stets große Abhängigkeiten von schwer zu kontrollierenden Randbedingungen geben würde. Die Messung wird dadurch extrem robust und wertet auch noch Signalverläufe sinnvoll aus, in denen überhaupt keine Pulse erkennbar sind. Schichten oberhalb des zu vermessenden Mediums dürfen dabei sogar noch in sich inhomogen sein, wie in manchen Fällen von Schaum, der praktisch eine Vielzahl von Grenzübergängen zwischen Schaumschichten unterschiedlicher Dichte bildet. Die Erfindung ermöglicht im Gegensatz zum Stand der Technik, TDR-Sensoren überhaupt für Schaummessung praktisch einsetzen zu können.

Die Referenzposition ist bevorzugt ein Sondenanfang. Dabei handelt es sich nicht unbedingt um den physischen Sondenanfang, wenn eine Sonde beispielsweise im Inneren des Sensorkopfes verschraubt ist, sondern um den Beginn des gewünschten Messbereichs für Füllstände. Im Signalverlauf kann diese Referenzposition beispielsweise an einem Puls erkannt werden, der fast unvermeidlich im Übergang von Sensorkopf zu Sonde entsteht. Die Referenzposition kann aber ebenso auch aus baulichen Eigenschaften des Sensors abgeleitet oder ab Werk beziehungsweise am Betriebsort kalibriert werden.

Die Signallaufzeit wird bevorzugt aus Signallaufzeitintervallen summiert, die eine Verzögerung der Signalausbreitung an der zu einem jeweiligen Signallaufzeitintervall gehörigen Sondenposition durch eine Korrektur mit dem bis zu dieser jeweiligen Sondenposition aufintegrierten Signalverlauf berücksichtigen. Das in das zweite Medium eindringende Sendesignal wird durch die dort im Vergleich mit Luft höhere relative elektrische Dielektrizitätskonstante verzögert. Dies soll bei der Umrechnung der Signallaufzeit in einen äquivalenten Signalweg für die Bestimmung eines Abstands des Grenzübergangs und damit des Füllstands kompensiert werden. Allerdings ist die Dielektrizitätskonstante regelmäßig unbekannt, beziehungsweise sie ändert sich im Falle von inhomogenem Schaum im Extremfall von Abtastpunkt zu Abtastpunkt des Signalverlaufs. Deshalb wird in dieser bevorzugten Weiterbildung eine Zeitanpassung vorgenommen. Die dabei an der jeweils betrachteten Sondenposition einwirkende Dielektrizitätskonstante wird mit Hilfe des bis dahin aufintegrierten Signalverlaufs geschätzt, um auf diese Weise die bis zu dieser Sondenposition reflektierten Signalanteile zu berücksichtigen.

In die Korrektur geht bevorzugt zusätzlich eine von der spezifischen Wellenausbreitung in dem Behälter abhängige Umgebungskonstante ein. Die maßgeblich durch den Behälter, vor allem dessen Geometrie festgelegte spezifische Umgebung der Sonde wirkt ebenfalls auf den Signalverlauf ein. Dies gilt verstärkt bei einer Monosonde. Um von diesen Einflüssen bei der Schätzung der relativen Dielektrizitätskonstante und der Zeitanpassung unabhängig zu werden, wird eine Umgebungskonstante bestimmt oder festgelegt. Die Zeitanpassung berücksichtigt also mindestens zwei Einflussgrößen, nämlich den aufintegrierten Signalverlauf und die Umgebungskonstante.

Die Umgebungskonstante wird bevorzugt in einer Kalibrationsmessung bei leerem Behälter bestimmt, bei der ein Integral des Signalverlaufs über einen Bereich eines am Sondenende entstehenden Artefaktpulses gebildet wird. Am Sondenende wird die nach Reflexionen an den diversen Grenzübergängen verbleibende Signalenergie reflektiert. Bei leerem Behälter ist dies praktisch das gesamte Signal, so dass ein ausgeprägter Puls entsteht. Der Puls ist gut händisch oder automatisch identifizierbar und befindet sich überdies an einer durch die Sondenlänge festgelegten fixen zeitlichen Position, da es bei leerem Behälter keine Signalverzögerungen aufgrund von Luft abweichender relativer Dielektrizitätskonstanten gibt. Durch Bezugnahme auf den Artefaktpuls können zahlreiche behälter- und geräteabhängige Faktoren und damit die zugehörigen Einsteüungsschritte und Berechnungen entfallen. Die bei der Diskussion des Standes der Technik geschilderten Probleme bei der Vermessung des Artefaktpulses stellen sich hier nicht, weil in einer kontrollierten, sehr einfachen Situation bei leerem Behälter gemessen wird. Obwohl der Artefaktpuls ein besonders einfaches und zuverlässiges Maß für die Umgebungskonstante darstellt, können prinzipiell auch die damit kompensierten geräte- und behälterspezifischen Einflüsse modelliert oder ausgemessen werden. Auch ist denkbar, anstelle des Artefaktpulses den Sendepuls oder einen Übergangspuls am Übergang zwischen Sensorkopf und Sonde heranzuziehen.

Der Grenzübergang wird bevorzugt durch einen Vergleich des aufintegrierten Signalverlaufs mit einem Schwellwert erkannt. Es wird also sukzessive der Signalverlauf von einem der Referenzposition entsprechenden Zeitpunkt an bis zu einem immer späteren betrachteten Zeitpunkt aufintegriert, bis der aufintegrierte Signalverlauf die Schwelle überschreitet. Der dabei zuletzt betrachtete Zeitpunkt wird als zu der Position des gesuchten Grenzübergangs gehörig angesehen und in einen Füllstand umgerechnet. Auf diese Weise wird ein sehr einfaches Verfahren angegeben, um den Grenzübergang stabil und gänzlich unabhängig von der Form des Signalverlaufs zu bestimmen, also insbesondere unabhängig davon, ob sich in dem Signalverlauf Pulse identifizieren lassen.

Für den Vergleich wird der Signalverlauf vorzugsweise ein zweites Mal aufintegriert, der zweiten Integration wird jedoch anstelle des Signalverlaufs selbst dessen Absolutbetrag oder der punktweise quadrierte Signalverlauf zugrunde gelegt. Der Signalverlauf kann nämlich auch negative Werte annehmen. Dies geschieht beispielsweise, wenn sich dichterer Schaum oberhalb von lockerem Schaum befindet. Ein anderes Beispiel ist eine Luftblase in einer Koaxialsonde. Für die Bestimmung der Signallaufzeit, insbesondere die Zeitanpassung, ist es richtig, dieses Vorzeichen zu berücksichtigen. Auch negative Anteile in dem Signalverlauf entsprechen aber reflektierter Sendeenergie. Da die Schwelle misst, wie viel Sendeenergie bereits oberhalb einer jeweils betrachteten Sondenposition durch Reflexionen verloren gegangen ist, sollte hierbei das Vorzeichen ignoriert werden. Dies geschieht durch Bilden des Absolutbetrags oder Quadrieren, wobei letzteres das physikalisch korrekte Maß für die Energie ergibt. Auch andere abgeleitete Größen anstelle eines Absolutbetrags oder punktweisen Quadrierens sind denkbar.

Der Grenzübergang wird bevorzugt in einem iterativen Verfahren erkannt, welches den Signalverlauf in durch die Abtastrate des Signalverlaufs vorgegebenen Schritten ab der Referenzposition bis zu einem Abbruchkriterium aufintegriert, nämlich ob der bis zu dem jeweiligen Schritt aufintegrierte Signalverlauf oder ein entsprechendes Integral des Absolutbetrags des Signalverlaufs oder des punktweise quadrierten Signalverlaufs den Schwellwert überschreitet. Ein solches iteratives Verfahren ist leicht in einen Algorithmus für eine digitale Verarbeitung umsetzbar.

Die zu bestimmende Signallaufzeit wird bevorzugt anfangs auf Null gesetzt und in jedem Schritt um ein Inkrement erhöht, das sich als Quotient berechnet, dessen Zähler von der Summe aus der Umgebungskonstanten und dem aufintegriertem Signalverlauf und dessen Nenner von der Differenz aus der Umgebungskonstante und dem aufintegriertem Signalverlauf gebildet wird. Damit erfolgt in einer iterativen Weise eine Zeitanpassung, um zu kompensieren, dass Zeitabstände in dem Signalverlauf nicht direkt Signallaufwegen entsprechen, sondern hier noch eine Signalverzögerung durch eine von Luft abweichende relative Dielektrizitätskonstante innerhalb eines Mediums eintritt. Mit der angegebenen Berechnung für das Inkrement wird diese Dielektrizitätskonstante an jeder Position geschätzt. Dabei fließen wie oben schon beschrieben einerseits die schon oberhalb der Position durch Reflexionen verlorenen Signalanteile, die in dem aufintegrierten Signalverlauf erfasst werden, und die konkreten Umgebungseinflüsse auf die Wellenausbreitung ein, die durch die Umgebungskonstante und insbesondere ein Integral über den Artefaktpuls vom Sondenende berücksichtigt werden.

Der Schwellwert wird bevorzugt durch eine Kalibrationsmessung bestimmt, bei der sich nur das erste Medium in dem Behälter befindet und ein Schwellwertintegral des Signalverlaufs im Bereich eines Echosignals an dem Grenzübergang zu dem ersten Medium gebildet wird. Dies ist ein einfaches Verfahren, um einen passenden Schwellwert unter kontrollierten Bedingungen zu bestimmen, nämlich ohne störendes zweites Medium. Dadurch ist sichergestellt, dass sich ein ausgeprägter, leicht zu erkennender und zu vermessender Mediumpuls bildet, über den dann das Schwellwertintegral integriert. Wie immer bedeutet Integral ein summarisches Maß für den Signalverlauf im betrachteten Bereich, zu dem die einzelnen Werte des Signalverlaufs beitragen. Ein solches Maß lässt sich beispielsweise durch numerische Integration bestimmen, die einfach im Aufsummieren der Werte des Signalverlaufs bestehen kann.

Der Schwellwert wird bevorzugt auf 90 % bis 110 % des Schwellwertintegrals gesetzt, um den Grenzübergang zu dem ersten Medium zu erkennen. Der Schwellwert wird damit nahezu oder gänzlich mit dem Schwellwertintegral gleichsetzt. Eine gewisse Entlastung von einer Identität ist sinnvoll, wobei ein Wert unterhalb 100 % sicherstellt, dass die Schwelle auch unter Rauscheinflüssen tatsächlich überschritten und damit ein Messwert generiert wird, der möglicherweise den Abstand des Grenzübergangs etwas unterschätzt. Umgekehrt überschätzt ein Wert oberhalb 100 % diesen Abstand und verhindert damit, dass fälschlich noch ein Füllstandswert innerhalb des oberen, zweiten Mediums ausgegeben wird.

Der Schwellwert kann vorzugsweise auch auf 5 % bis 30 % des Schwellwertintegrals gesetzt werden, um den Grenzüberganz zu dem zweiten Medium zu erkennen. Dieser Schwellwert soll also nahe bei Null liegen und nur so groß sein, dass nicht schon bloßes Rauschen als Grenzübergang erkannt wird. Damit wird der oberste Grenzübergang, also der Füllstand des zweiten Mediums und insbesondere die Schaumoberfläche gemessen. Je weiter die Schwelle von Null abweicht, umso sicherer differenziert sie vom Rauschen, überschätzt dafür aber auch zunehmend den Abstand des obersten Grenzübergangs, misst also zunehmend tiefer in das zweite Medium hinein.

Denkbar ist auch, die Schwelle sowohl in die Nähe von 100 % als auch etwas oberhalb von Null zu setzen, d.h. effektiv zwei Schwellen zu verwenden. Dadurch wird der oberste Grenzübergang zu dem zweiten Medium hin und der Grenzübergang zu dem ersten Medium gemessen. Man erhält also beide Füllstände und damit auch die Dicke der Schicht des zweiten Mediums beziehungsweise der Schaumschicht.

Der Grenzübergang zu dem zweiten Medium wird bevorzugt daran erkannt, dass der aufintegrierte Signalverlauf sich ab dem Grenzübergang systematisch von Null unterscheidet. Sobald der aufintegrierte Signalverlauf sich von Null unterscheidet, gab es eine erste Signalreflexion, somit ist an dieser Stelle das Signal in das oberste Medium eingetreten. Allerdings genügt es praktisch nicht, lediglich mit Null zu vergleichen, da dies auch durch Rauscheffekte eintritt. Betrachtet man aber den aufintegrierten Signalverlauf über einen größeren Bereich, so lässt sich erkennen, ob die Abweichung von Null systematisch oder lediglich dem Rauschen geschuldet ist. Dieses Vorgehen ist eine Alternative zu einem Schwellwertverfahren, wobei auch beide Verfahren eingesetzt und gegenseitig plausibilisiert oder die Ergebnisse miteinander verrechnet werden können.

Der Signalverlauf, der aufintegrierte Signalverlauf und/oder der Schwellwert werden bevorzugt um einen Driftkorrekturwert skaliert. Hierbei ist eine wichtige Ursache für Driften die Temperatur. Der Driftkorrekturwert wird beispielsweise bestimmt, indem ein Übergangspuls am Sondenanfang oder der Sendepuls selbst mit einem zuvor eingelernten Referenzübergangspuls verglichen wird. Dieser Übergangspuls ist weitgehend unabhängig von dem Füllstand, so dass dessen Veränderungen auf Driften zurückgeführt werden können. Es wird dann angenommen, dass solche Driften in gleichem Maße den Übergangspuls skalieren wie den übrigen Signalverlauf.

Der Signalverlauf wird bevorzugt mit einer füllstandsabhängigen Amplitudenkennlinie reskaliert. Im oberen Messbereich ergeben sich nämlich Mehrfachreflexionen, bei denen von einer Mediumsoberfläche zu dem Sondenanfang zurückkehrende Signalanteile erneut in den Behälter hinein reflektiert werden. Dies kann sich durchaus mehrfach wiederholen. Auf diese Weise werden effektiv dem eigentlichen Sendepuls unmittelbar und diesen überlagernd noch Tochterpulse hinterhergesandt, die sich mit jeder Mehrfachreflexion weiter abschwächen. Das Ergebnis sind höhere Amplituden im oberen Messbereich. Man kann diesen Effekt modellieren oder bei verschiedenen Füllständen ausmessen und auf diese Weise eine füllstandsabhängige Amplitudenkennlinie bestimmen, die in Abhängigkeit von einem Füllstand die Signalüberhöhung aufgrund von Mehrfachreflexionen als Faktor enthält. Diese Amplitudenkennlinie wird im oberen Messbereich über Eins liegen und dann bei Füllständen, bei denen diese Mehrfachreflexionen keine Rolle mehr spielen, auf Eins abfallen, um bei größeren Entfernungen wegen Dämpfung sogar unter Eins abzusinken. Durch Reskalieren des Signalverlaufs mit der Amplitudenkennlinie wird dieser Störeffekt kompensiert.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:

Fig. 1 eine schematische Querschnittsdarstellung eines Füllstandssensors in einem Behälter;

Fig. 2 ein schematisches Blockdiagramm eines Sensorkopfes des Füllstandssensors gemäß Figur 1;

Fig. 3 ein beispielhafter schematischer Signalverlauf bei gut getrennten Messpulsen von Grenzübergängen an zwei Medien als Vergleich;

Fig. 4 im oberen Teil einen Signalverlauf mit Kennzeichnung des als Grenzübergang zu einem ersten Medium erkannten Zeitpunkts in einem Beispiel eines Behälters mit einer Flüssigkeit und einer darüber angeordneten dicken Schaumschicht; im mittleren Teil eine Darstellung des aufintegrierten Signalverlaufs und des Schwellübertritts; im unteren Teil eine Darstellung der korrigierten Laufzeit im Vergleich mit einer Laufzeit in Luft;

Fig. 5 Darstellungen gemäß Figur 4 in einem Beispiel eines Behälters mit einer Flüssigkeit und einer darüber angeordneten dünneren Schaumschicht, deren Dichte kontinuierlich zunimmt;

Fig. 6 Darstellungen gemäß Figur 4 in einem Beispiel eines Behälters mit einer Flüssigkeit und einer darüber angeordneten dünneren Schaumschicht von anderer Konsistenz als in Figur 5; und

Fig. 7 Darstellungen gemäß Figur 4 in einem Beispiel eines Behälters, in dem sich nur Schaum befindet.

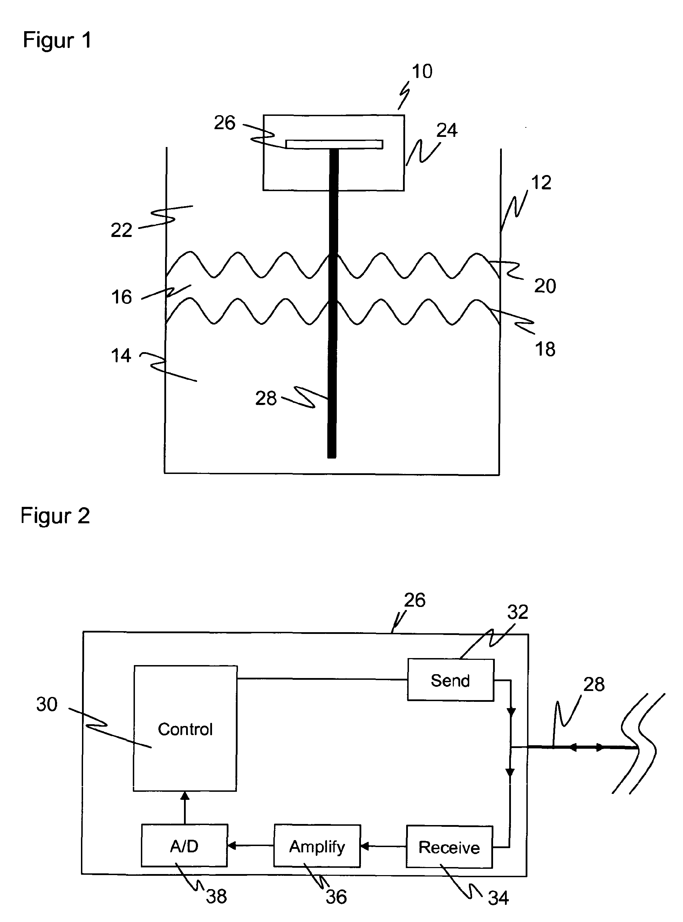

Figur 1 zeigt schematisch einen TDR-Sensor 10, der als Füllstandssensor in einem Tank oder Behälter 12 mit einer Flüssigkeit oder allgemein einem Medium 14 angebracht ist. Über dem Medium 14 befindet sich ein zweites Medium 16, beispielsweise Schaum in unterschiedlicher Konsistenz, oder eine Ölschicht als zweites Medium 16 auf Wasser als eigentlichem Medium 14. Die relative Permittivität oder relative Dielektrizitätskonstante $\varepsilon_{r2}$ in dem zweiten Medium entspricht weder Luft noch dem Medium 14 und kann innerhalb des zweiten Mediums 16 in unterschiedlichen Höhenlagen variieren.

Das Medium 14 bildet gegenüber dem zweiten Medium 16 eine erste Grenzfläche 18 beziehungsweise einen ersten Grenzübergang und das zweite Medium 16 eine zweite Grenzfläche 20 gegenüber der oberhalb befindlichen Luft. Der Sensor 10 ist dafür ausgebildet, die Entfernung zumindest zu einer der Grenzflächen 20, 22 zu ermitteln und daraus aus seiner bekannten Anbringungslage den Füllstand und bei Bedarf anhand der Geometrie des Behälters 12 auch die Menge des Mediums 14 beziehungsweise des zweiten Mediums 16 abzuleiten. Das grundsätzliche Vorgehen entspricht dabei dem einleitend beschriebenen und an sich bekannten TDR-Verfahren, unterscheidet sich jedoch in der noch zu erläuternden verbesserten Auswertung. Obwohl die Ausbildung des Sensors 10 als Füllstandssensor für Flüssigkeiten ein sehr wichtiges Einsatzfeld ist, kann der Sensor 10 prinzipiell auch für andere Medien eingesetzt werden. Dabei ist insbesondere an Schüttgut oder Granulate zu denken.

Der Sensor 10 weist einen Sensorkopf 24 mit einer Steuerung 26 auf, die vorzugsweise auf einer gemeinsamen Platine untergebracht ist. Alternativ sind mehrere über Stecker verbundene Leiterplatten oder Flexprintträger denkbar. An die Steuerung 24 ist eine Sonde 28 angeschlossen, die hier als offene Monosonde ausgebildet ist und so unter anderem den Vorteil hat, dass sie für Anwendungen im Hygienebereich leicht gereinigt werden kann. Die Sonde 28 kann aber auch eine Koaxialsonde sein.

Die in dem Sensorkopf 24 vorgesehene Steuerung 26 beziehungsweise ihre Platine ist in Figur 2 in einem Blockschaltbild dargestellt. Die eigentliche Steuer- und Auswertungseinheit 30 ist auf einem digitalen Baustein implementiert, beispielsweise ein Mikroprozessor, ASIC, FPGA oder ein ähnlicher digitaler Logikbaustein sowie eine Kombination mehrerer derartiger Bausteine. Wie auch schon einleitend beschrieben, wird bei einer Messung ein Signal, vorzugsweise ein Puls über einen Mikrowellensender 32 auf die Sonde 28 gegeben und die Laufzeit des an einer Grenzfläche 18, 20 entstehenden und in einem Mikrowellenempfänger 34 empfangenen Reflexpulses gemessen, um den Abstand der Grenzfläche 18, 20 und damit den Füllstand in dem Behälter 12 zu ermitteln. Das Empfangssignal des Mikrowellenempfängers 34 wird für die Auswertung nach Verstärkung in einem Verstärker 36 mit einem Digital/Analogwandler 38 digitalisiert.

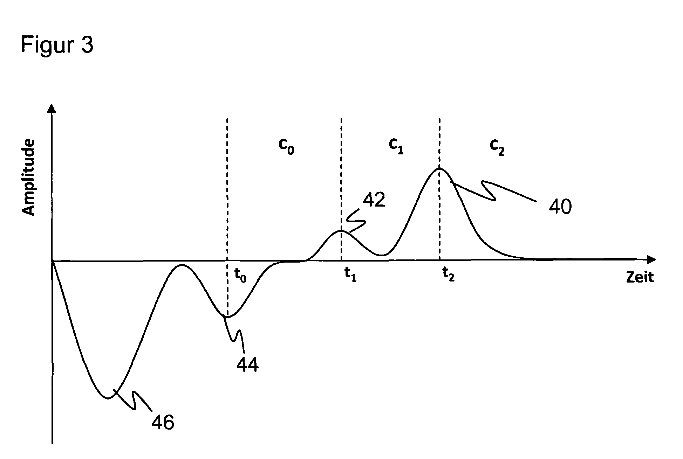

Figur 3 zeigt zur Illustration einen schematischen Signalverlauf mit gut getrennten Messpulsen 40, 42 an den Grenzflächen 18, 20. In einem solchen Signalverlauf könnten herkömmliche Auswertungen die Messpulse 40, 42 ohne Weiteres lokalisieren. Schwierigkeiten entstehen dann, wenn die Messpulse 40, 42 ineinander laufen. Bisher unlösbar wird das Problem, Messpulse 40, 42 zu identifizieren, wenn das zweite Medium 16 in sich inhomogen ist und somit eine Vielzahl sich überlagernder Pulse unbekannter Anzahl erzeugt.

Der Signalverlauf enthält noch weitere Pulse, nämlich einen Übergangspuls 44 am Sondenanfang im Übergang zwischen Sensorkopf 24 und Sonde 28 sowie den Sendepuls 46 selbst. Weiter rechts und nicht mehr dargestellt entsteht noch ein Artefaktpuls am Sondenende, wo die nach den Reflexionen an den Grenzflächen 18, 20 verbleibende Restenergie des Sendesignals reflektiert wird.

Um erfindungsgemäß Füllstände der Medien 14, 16 auch im allgemeinen Fall bei nicht mehr identifizierbaren Messpulsen 40, 42 bestimmen zu können, wird der nachfolgend beschriebene Ansatz verfolgt:

Die Amplituden der Reflexionen in dem Signalverlauf sind ein Maß für die Impedanzänderung in dem Behälter 12 und damit auch ein Maß für die Änderung der relativen elektrischen Dielektrizitätskonstanten an einer jeweiligen Grenzschicht 18, 20. Die Höhe eines Pulses in dem Signalverlauf hängt von dieser Änderung der Dielektrizitätskonstanten und der durch bereits oberhalb erfolgte Reflexionen verlorengegangenen Signalenergie ab. Die Form des jeweiligen reflektierten Pulses bleibt erhalten, die Pulse unterscheiden sich nur in ihrer Höhe.

Damit kann der Signalverlauf $S$ als lineare Überlagerung der Pulsform $s(t)$ mit lediglich unterschiedlichen Skalierungen durch die Höhen $a_n$ und unterschiedlichen zeitlichen Positionen $t_n$ der $n$ Pulse angesehen werden:

$$S = \sum_{i=1}^{n} s(t - t_n) a_n .$$

Die konstante Pulsform $s(t)$ bedeutet auch, dass sich ein Integral über den Signalverlauf $S$ aus über die Höhen skalierten Integralen über diese Pulsform $s(t)$ zusammensetzt:

$$\int a_n s(\tau - t_n) d\tau = a_n \int s(\tau - t_n) d\tau .$$

Sowohl der Signalverlauf $S$ selbst als auch dessen Amplituden, damit auch für das Integral $I(t)$ über den Signalverlauf, sind jeweils Funktionen der Dielektrizitätskonstanten $\varepsilon_r$. Dabei gilt ferner

$$I(t) = \int_{0}^{t} S(\tau) d\tau = \int_{0}^{t} \sum_{i=1}^{N} s(\tau - t_n) a_n d\tau .$$

Wie Figur 3 illustriert, unterscheiden sich die Signalausbreitungsgeschwindigkeiten $c$ der elektrischen Welle in den verschiedenen Schichten, und zwar in Ab-

hängigkeit von der Dielektrizitätskonstanten $\varepsilon_r$. Während in Luft mit praktisch $\varepsilon_r=1$ die Vakuumlichtgeschwindigkeit $c_0$ angenommen werden kann, verzögert sich innerhalb der Medien 14, 16 die Geschwindigkeit um $\dfrac{1}{\sqrt{\varepsilon_r}}$. Demnach ist der zu einem Zeitschritt $\Delta T$ der Signallaufzeit, beispielsweise einer Abtastperiode des A/D-Wandlers 38, äquivalente Weg bei Dielektrizitätskonstanten $\varepsilon_{r1}$, $\varepsilon_{r2}$ des ersten Mediums 14 beziehungsweise des zweiten Mediums 16

- für Luft: $c_0 \Delta T$

- für das erste Medium 14: $\dfrac{c_0 \Delta T}{\sqrt{\varepsilon_{r1}}}$ und

- für das zweite Medium 16: $\dfrac{c_0 \Delta T}{\sqrt{\varepsilon_{r2}}}$ .

Dies sollte vorzugsweise bei der Auswertung durch eine entsprechende Zeitanpassung berücksichtigt werden, weil sonst die Abstände der Grenzflächen 18, 20 systematisch überschätzt werden. Die Dielektrizitätskonstanten sind aber entweder mangels Kenntnis über die Medien 14, 16 oder beispielsweise im Falle eines inhomogenen Schaums mit über die Höhe variierender Dichte sogar prinzipiell vorab nicht bekannt.

Sofern sich wie in einer Situation gemäß Figur 3 die Amplitude $A_1$ des Messpulses 40 von dem ersten Medium 14 bestimmen lässt, kann die zugehörige Dielektrizitätskonstante $\varepsilon_{r1}$ berechnet werden. In einem Vorgehen, das die einleitend zitierte DE 10 2012 101 725 näher erläutert, auf die hierzu ergänzend verwiesen wird, bestimmt man zunächst eine Referenzamplitude $A_{end}$ des Artefaktpulses vom Sondenende. Dadurch können Effekte der Geometrie des Behälters 12 und sonstigen Signalveränderungen berücksichtigt werden. Die Referenzamplitude $A_{end}$ wird beispielsweise berechnet, simuliert oder durch eine auch wiederholte Kalibrationsmessung im leeren Zustand des Behälters 12 bestimmt. Es gilt dann

$$\varepsilon_{r1} = \frac{A_{end} - A_1}{A_{end} + A_1}$$

Wie alle Pulse erfüllt auch der Artefaktpuls die Beziehung

$$\int A_{end} s_{end}(t)\,dt = A_{end} \int s_{end}(t)\,dt \,,$$

so dass insbesondere die Amplitude $A_{end}$ des Artefaktpulses zu dessen Fläche proportional ist.

Aus einem kontinuierlichen Übergang der Wellenimpedanz innerhalb des zweiten Mediums 16 von der Wellenimpedanz der Luft zu der Wellenimpedanz des ersten Mediums 14 resultiert eine Vielzahl sich überlagernder Pulse. Eine Einzelpulsauswertung wie in Figur 3 ist dann nicht mehr möglich, ebenso wenig wie $\varepsilon_{r1}$ aus $A_1$ und $A_{end}$ berechnet werden kann.

Möglich ist aber eine Auswertung von Integralen über den Signalverlauf $S$ und entsprechender Integrale über den Artefaktpuls oder weiterer Integrale, die man als Parameter in kontrollierter Situation beispielsweise bei leerem Behälter oder bei einem Behälter ohne zweites Medium 16 bestimmt. Man trennt also den Signalverlauf $S$ gar nicht mehr in diskrete Pulse, sondern unterstellt in jedem Punkt eine hypothetische oder tatsächliche Reflexion wegen einer Änderung der Dielektrizitätskonstanten. Dann wird die Stelle in dem Signalverlauf $S$ lokalisiert, an dem so viel Signalenergie reflektiert wurde, wie in einer Vergleichssituation ohne zweites Medium 16, und diese Stelle wird als die erste Grenzfläche 18 erkannt. Um deren Abstand richtig zu bestimmen, sollte vorzugsweise bei der Umrechnung der Signallaufzeit in einen Weg die Verzögerung durch das zweite Medium 16 berücksichtigt werden.

Dieses Vorgehen setzt eine vereinfachende Annahme voraus, wobei sich aber in praktischen Messungen zeigt, dass trotz dieser Vereinfachung gute Messergebnisse erhalten werden. Es wird nämlich angenommen, dass die ausgesandte Signalenergie, die an der ersten Grenzfläche 18 ankommt, unabhängig von dem Verlauf der Impedanzänderungen oberhalb der ersten Grenzfläche 18 ist. Es wird also der gleiche Energieverlust des Signals durch vorhergehende Reflexionen unterstellt, egal in welcher Weise sich die Dielektrizitätskonstante von 1 in der oberen Luftschicht zu $\varepsilon_{r1}$ an der ersten Grenzfläche 18 ändert, ob also beispielsweise in einem Sprung direkt an der ersten Grenzfläche 18, zwischen der zweiten Grenzfläche 20 und der ersten Grenzfläche 18 monoton anwachsend wie bei einem immer dichter werdenden Schaum oder mit jedem beliebigen anderen Verhalten. Die gegen diese Näherung robusten Messungen lassen vermuten, dass besonders pathologische Verläufe praktisch nicht auftreten.

Diese allgemeinen Überlegungen können beispielhaft in einem konkreten Algorithmus illustriert werden. Die Erfindung soll aber dadurch nicht auf diesen Algorithmus beschränkt werden, sondern umfasst auch andere Umsetzungen des soeben geschilderten Vorgehens.

Vorbereitend wird in einem ersten Schritt in Analogie zu der DE 10 2012 101 725 der Artefaktpuls vom Sondenende bei leerem Behälter 12 vermessen, um die Umgebungseinflüsse der konkreten Einbausituation des TDR-Sensors 10 zu erfassen. Allerdings wird entsprechend der hier vorgestellten Integralmethode nicht dessen Amplitude bestimmt, sondern das Integral $I_{end}$ über den Signalverlauf $S$ im Bereich des Artefaktpulses gebildet, wobei hier aber wie oben dargelegt eine Proportionalitätsbeziehung besteht.

In einem zweiten vorbereitenden Schritt wird der Behälter 12 nur mit dem ersten Medium 14 befüllt und darauf geachtet, dass sich auch kein Schaum als zweites Medium 16 bildet beziehungsweise dieser sich aufgelöst hat. In dieser kontrollierten Umgebung ist sichergestellt, dass ein klar erkennbarer Messpuls 40 oder Mediumpuls an der ersten Grenzfläche 18 erzeugt wird. Über den Messpuls 40 wird dann das Integral $I_{Medium}$ gebildet. Diese Vermessung erfolgt in erster Linie, um die unterschiedlichen Einflüsse der Dielektrizitätskonstanten $\varepsilon_{r1}$ des ersten Mediums 14 zu kompensieren und könnte daher alternativ durch eine Vorgabe oder unabhängige Messung der Dielektrizitätskonstanten $\varepsilon_{r1}$ ersetzt werden, beispielsweise durch anschließende Berechnung von $I_{Medium}$ anhand der bekannten Pulsform $s(t)$.

Während der eigentlichen Messung wird dann der Signalverlauf $S$ von einem Anfangswert $t_0$, beispielsweise entsprechend dem Sondenanfang oder einem gewählten höchstmöglichen Füllstand, bis zu einem jeweils betrachteten Zeitpunkt $t$ aufintegriert. Es wird also ein aufintegrierter Signalverlauf $I_S(t) = \int_0^t S(\tau)d\tau$ gebildet, der eine Funktion des jeweils betrachteten Zeitpunkts $t$ ist.

Die Position der Grenzfläche 18 wird dann durch Vergleich des aufintegrierten Signalverlauf $I_S$ mit der Referenz $I_{Medium}$ gefunden. Dazu wird beispielsweise bestimmt, für welches $t$ $I_S(t)=K\cdot I_{Medium}$ gilt, wobei $K$ ein Skalierungsfaktor ist. Wird $K$ in der nähe von Eins gewählt, so entspricht $t$ der Position der ersten Grenzfläche 18. Bei einer Wahl von $K$ nur etwas oberhalb Null dagegen wird die Position der zweiten Grenzfläche 20 gefunden. Eine Kombination ermöglicht zusätzlich, die Schichtdicke des zweiten Mediums 17 zu messen.

Das aufgefundene $t$ entspricht nun aber einer Signallaufzeit, die sich aus Beiträgen von Signalwegen in Luft, im zweiten Medium 16 und eventuell auch noch Anteilen im ersten Medium 14 zusammensetzt. Daher werden Füllstände systematisch unterschätzt, wenn nicht der äquivalente Weg durch Zeitanpassung anhand der unterschiedlichen Wellenausbreitungsgeschwindigkeiten korrigiert wird. Eine solche Zeitanpassung ist unter Verwendung des aufintegrierten Signalverlaufs $I_S$ möglich und wird noch genauer, wenn zusätzlich die Umgebungseinflüsse beispielsweise durch $I_{end}$ berücksichtigt werden. Konkret kann die Zeitanpassung dann in Analogie der oben zitierten Rechenvorschrift $\varepsilon_{r1} = \dfrac{A_{end-}A_1}{A_{end}+A_1}$ anhand des Terms $\dfrac{I_{end}-I_S}{I_{end}+I_S}$ erfolgen.

In der praktischen Umsetzung liegt der Signalverlauf $S$ typischerweise als Zeitreihe $S[i]$ von diskreten Abtastungen vor. Deshalb bietet sich in einer bevorzugten Ausführungsform an, die Auswertungen iterativ vorzunehmen und den aufintegrierten Signalverlauf $I_S$ sowie die Zeitanpassung schrittweise zu berechnen. Dazu werden anfänglich alle Werte mit Null initialisiert und dann beginnend vom Anfang des Messbereichs bei $t_0$ schrittweise für die nachfolgenden Abtastungen iterativ angepasst. Als Abbruchkriterium dient, wenn $I_S$ einen aus dem Referenzwert $I_{Medium}$ abgeleiteten Schwellwert $K\cdot I_{Medium}$ erreicht.

In Pseudocode lässt sich dann eine beispielhafte iterative Auswertung wie folgt darstellen:

$$I_S = 0\,;\ i = 0\,;\ t = 0$$

$$\text{WHILE } (\,I_S < K \cdot I_{Medium}\,)$$

$$I_S = I_S + S[i]\,;$$

$$t = t + \frac{I_{end} + I_S}{I_{end} - I_S}\,;$$

$$i = i + 1\,;$$

$$\text{END}$$

Dabei ist zu beachten, dass $I_{end}$ wie der Artefaktpuls selbst negativ ist. Außerdem sollte der Korrekturwert für die Zeitanpassung $\dfrac{I_{end} + I_S}{I_{end} - I_S}$ vorzugsweise darauf geprüft werden, ob er im Intervall [0,1 ...1] liegt, da er sonst unplausibel wäre.

Das Ergebnis ist die bereits um die unterschiedlichen Signalausbreitungsgeschwindigkeiten in den Medien 14, 16 korrigierte Signallaufzeit $t$, deren Einheit Abtastschritte sind. Die Abtastrate ist bekannt, so dass dies unmittelbar in eine absolute Laufzeit und mittels der Vakuumlichtgeschwindigkeit $c_0$ auch in einen Abstand umgerechnet werden kann. Vorteilhafterweise wird vorab die Konstante berechnet, die diese Umrechung von Signallaufzeit in Abtastschritten in einen Abstand durch einfache Multiplikation leistet.

Insbesondere wenn das zweite Medium 16 Schaum ist, kann sich noch eine Sondersituation ergeben. Es ist nämlich denkbar, dass die Dielektrizitätskonstante mit zunehmendem Abstand nicht monoton ansteigt, sondern sich auch Impedanzsprünge mit umgekehrtem Vorzeichen ergeben. Dies geschieht beispielsweise dann, wenn eine dichtere Schaumschicht auf einer dünneren Schaumschicht aufliegt oder sich Luftblasen bilden. Das Resultat sind reflektierte Pulse mit umgekehrtem Vorzeichen beziehungsweise negative Werte im Signalverlauf $S$. Dies führt dazu, dass $I_S$ trotz zunehmender Eindringtiefe des Signals vorübergehend abnimmt. Damit wird der Abstand der Grenzfläche 18 überschätzt, schlimmstenfalls sogar die Schwelle $K\cdot I_{Medium}$ nie erreicht. Die Energie, die zurückreflektiert wird, bis sich die Welle im Medium 14 befindet, ist jedoch näherungsweise unabhängig von den einzelnen Stufen der Impedanzänderungen darüber. Deshalb sollte die Abbruchbedingung vorzugsweise statt auf dem vorzeichenbehafteten Signalverlauf *S* auf dessen Absolutbetrag oder Quadrat beruhen. Dazu wird ein zweites Integral $I_{Stop}$ eingeführt, das über den Absolutbetrag oder in ganz analoger Weise das Quadrat oder ein ähnliches geeignetes Moment aufsummiert.

Es ergibt sich dann eine weitere bevorzugte Ausführungsform der Auswertung, die sich in diesem Pseudocode zusammenfassen lässt:

$$I_S = 0\,;\ I_{Stop} = 0\,;\ i = 0\,;\ t = 0$$

$$\text{WHILE}\ (I_{Stop} < K \cdot I_{Medium})$$

$$I_S = I_S + S[i]\,;$$

$$I_{Stop} = I_{Stop} + |S[i]|\,;$$

$$t = t + \frac{I_{end} + I_S}{I_{end} - I_S}\,;$$

$$i = i + 1\,;$$

END

In dem Pseudocode erfolgt die Integration jeweils auf einfachste Weise durch Aufsummieren der Werte des Signalverlaufs *S*. Die Erfindung umfasst ebenso andere Verfahren der numerischen Integration. Ähnlich ist auch die konkrete Formel für die Zeitanpassung austauschbar. Dabei wird zwar vorzugsweise ebenfalls der aufintegrierte Signalverlauf verwendet, denn dieser berücksichtigt die oberhalb des im jeweiligen Iterationsschritt betrachteten Zeitpunkts durch Reflexion verlorengegangene Signalenergie. Die Umgebungseinflüsse können aber auch anders als über den Artefaktpuls durch $I_{End}$ berücksichtigt werden, insbesondere indem ein anderer Puls wie der Übergangspuls 44 oder sonstige Informationen aus dem Signalverlauf *S* herangezogen werden.

Vorbereitend kann der Signalverlauf *S* noch auf verschiedene Arten korrigiert werden. So kann eine Reskalierung zur Kompensation von Driften, insbesondere eine Temperaturkompensation erfolgen, beispielsweise indem der Übergangspuls 44 am Sondenanfang oder der Sendepuls 46 mit einer Referenz verglichen wird, um die Drifteinflüsse zu schätzen.

Eine weitere Kompensationsmöglichkeit besteht darin, den Signalverlauf um eine Amplitudenkennlinie zu korrigieren. Denn der Signalverlauf *S* ist für kleine Zeiten entsprechend dem oberen Bereich des Behälters überhöht, weil Mehrfachreflexionen zwischen Sondenanfang und Grenzfläche 18, 20 auftreten. Dieser Einfluss lässt sich vorab bestimmen und in positions- beziehungsweise zeitabhängige Überhöhungsfaktoren ausdrücken, die dann durch die Amplitudenkennlinie ausgeglichen werden. Auch dies ist in der DE 10 2012 101 725 näher erläutert, auf die ergänzend verwiesen wird.

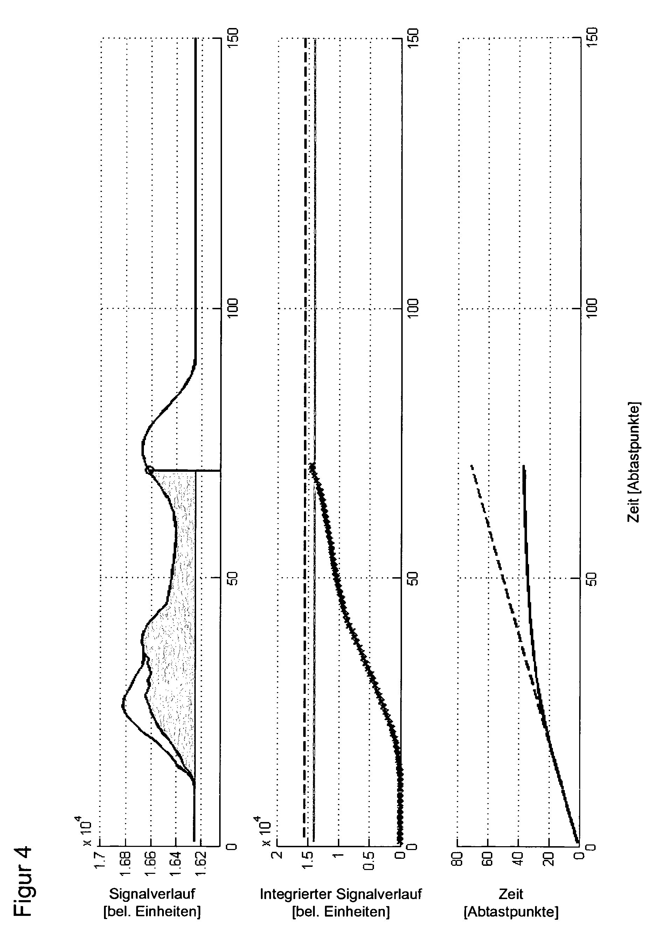

Abschließend soll die Erfindung gemäß den Figuren 4 bis 7 am Beispiel verschiedener Schaumschichten als Medium 16 illustriert werden.

Figur 4 zeigt im oberen Teil den Signalverlauf *S* mit Kennzeichnung des als Grenzübergang 18 zu dem ersten Medium 14 erkannten Zeitpunkts in einem Beispiel eines Behälters 12 mit einer Flüssigkeit als erstem Medium 14 und einer darüber angeordneten dicken Schaumschicht als zweitem Medium 16.

Dazu ist zunächst zu beachten, dass der höhere Kurvenzug in einem ersten Schritt wie soeben beschrieben mit einer Amplitudenkennlinie korrigiert wurde, um eine anfängliche Signalüberhöhung durch Mehrfachreflexionen auszugleichen. Der tatsächlich der Auswertung zugrunde gelegte Signalverlauf *S* ist also die niedrigere Kurve, in der auch mit grau die als integrierter Signalverlauf $I_S$ ausgemessene Fläche hervorgehoben ist. Bei dem senkrechten Strich ungefähr an der 70sten Abtastung wurde die erste Grenzfläche 18 erkannt.

Im mittleren Teil zeigt die Figur 4 den bis zum jeweiligen Abtastpunkt integrierten Signalverlauf $I_S$, der die graue Fläche unter dem Signalverlauf *S* des oberen Teils von Figur 4 schrittweise aufintegriert. Etwa bei der 70sten Abtastung entsprechend der Position des senkrechten Striches im oberen Teil der Figur 4 wird von dem integrierten Signalverlauf $I_S$ eine als dünne graue Linie gezeigte Schwelle überschritten, woran die Auswertung die erste Grenzfläche 18 erkennt. Diese Schwelle liegt in mehreren Ausführungsformen bei $K \cdot I_{Medium}$. Die gestrichelte Linie entspricht der gesamten Energie des Sendepulses und kann frühestens am Sondenende überschritten werden

Im unteren Teil illustriert Figur 4 die Zeitanpassung. Die gestrichelte Linie entspricht der ungestörten Wellenausbreitung in Luft mit maximaler Geschwindigkeit $c_0$. Durch den Korrekturfaktor $\dfrac{I_{end} + I_S}{I_{end} - I_S}$ wächst die für die äquivalente Wegeausbreitung benötigte angepasste Zeit langsamer an, wie mit durchgezogener Linie gezeigt. Dem Abtastwert, der dem Abbruchkriterium entspricht, der in Figur 4 etwa beim 70sten Abtastwert liegt, kann die angepasste Signallaufzeit bis zu der ersten Grenzfläche 18 abgelesen werden und in einen Füllstand umgerechnet werden.

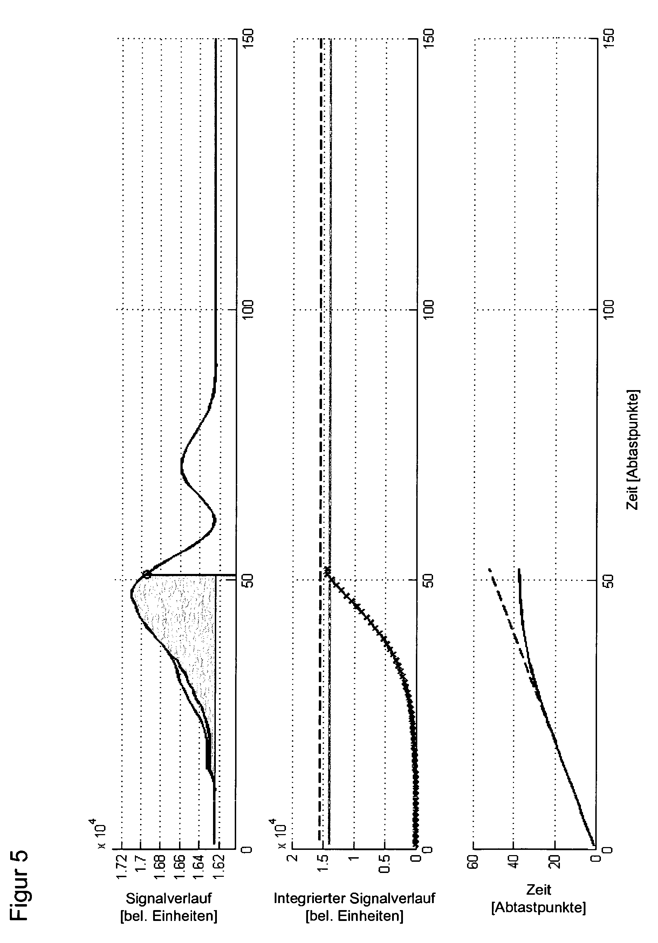

Figur 5 zeigt ganz analog ein weiteres Beispiel eines Behälters 12 mit einer Flüssigkeit als erstem Medium 14 und einer darüber angeordneten dünneren Schaumschicht als zweites Medium 16, deren Dichte kontinuierlich zunimmt.

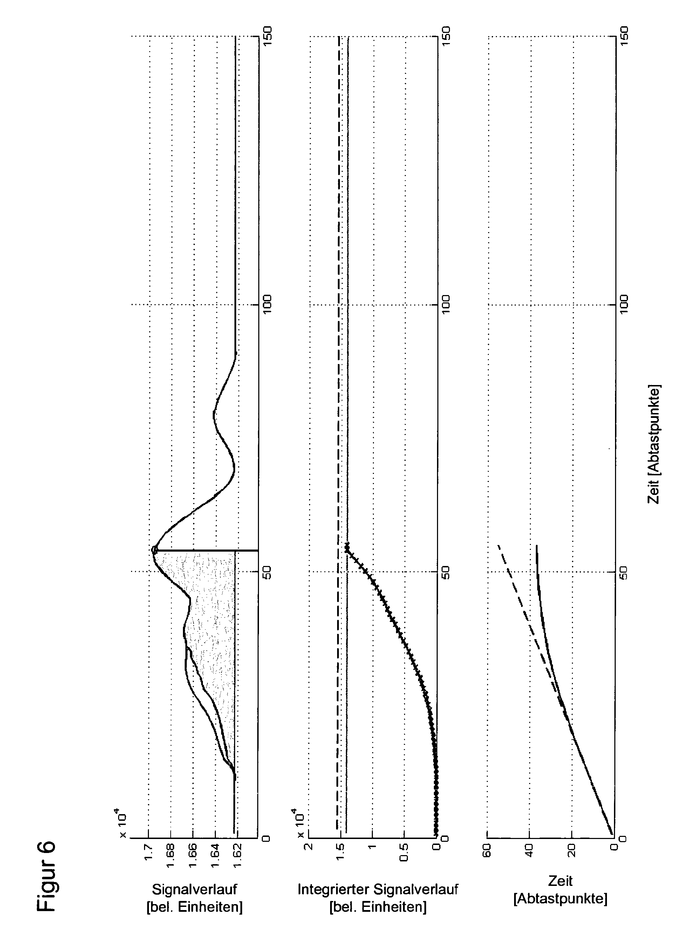

In dem Beispiel der Figur 6 hat die Schaumschicht nochmals eine andere Konsistenz und Dicke.

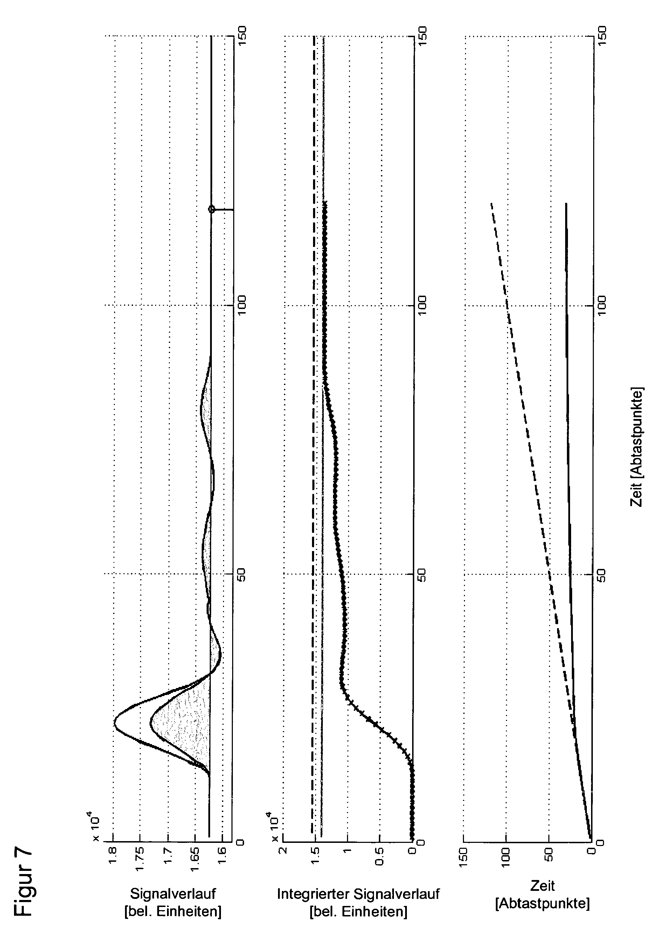

Figur 7 zeigt einen Fall, in dem sich nur Schaum als einziges Medium 14, 16 in dem Behälter 12 befindet.

Die Schwelle wird hier erst sehr weit hinten überschritten, je nach Einstellung von $K$ erst für Werte, die einem negativen Füllstand entsprechen würden und daher den Schluss erlauben, dass kein Medium 14 in dem Behälter 12 vorhanden ist. Ein herkömmlicher Algorithmus hätte den ausgeprägten ersten Puls oder einen der beiden Tochterpulse erkannt und den entsprechenden, viel zu hohen Füllstand trotz an sich außer dem Schaum leerem Behälter ausgegeben.

Soll der Füllstand des zweiten Mediums 16 bestimmt werden, so kann dies nach obigem durch Wahl eines $K$ nahe bei Null erreicht werden. Alternativ ist die zweite Grenzfläche 20 aber auch daran zu erkennen, dass der integrierte Signalverlauf $I_S$ sich systematisch von Null unterscheidet. Dies ist jeweils im mittleren Teil der Figuren 4 bis 7 erkennbar. Zum gleichen Zeitpunkt weicht auch die angepasste Zeit in dem unteren Teil der Figuren 4 bis 7 erstmals systematisch von der Ursprungsgerade der nicht kompensierten Zeit ab. Mit systematischer Abweichung ist hier jeweils gemeint, dass eine geringfügige Abweichung allein aufgrund von Rauscheinflüssen noch nicht gewertet werden soll. Dies ist beispielsweise mit Hilfe eines Glättungsfilters unterscheidbar.

Die Erfindung wurde für eine Füllstandsmessung eines Mediums 14 mit einer darüber befindlichen Schicht eines zweiten Mediums 16 beschrieben. Selbstverständlich wird aber mit demselben Vorgehen auch ein Füllstand eines Mediums gemessen, wenn sich darüber keine weitere Schicht befindet. Eine Verallgemeinerung des Verfahrens auf nicht geführte Wellen, also einen Sensor 10 ohne Sonde 28 wie einen Radarsensor, ist prinzipiell auch vorstellbar.

**Patentansprüche**

1. Verfahren zur Füllstandsmessung in einem Behälter (12) mit einem ersten Medium (14) und mindestens einem darüber angeordneten zweiten Medium (16), insbesondere einer Schaumschicht, bei dem ein elektromagnetisches Signal ausgesandt wird, insbesondere entlang einer in dem Behälter (12) angeordneten Sonde (28), und ein Signalverlauf (S) des in dem Behälter (12) reflektierten Signals aufgezeichnet wird, wobei anhand des Signalverlaufs (S) eine Signallaufzeit ($t$) bis zu einem Grenzübergang (18, 20) zu dem ersten Medium (14) oder zu dem zweiten Medium (16) und aus der Signallaufzeit ($t$) ein Füllstand des ersten Mediums (14) oder ein Füllstand des zweiten Mediums (16) bestimmt wird,
**dadurch gekennzeichnet,**
**dass** ein ab einer Referenzposition ($t_0$) aufintegrierten Signalverlauf ($I_S(t)$) als Funktion eines jeweils betrachteten Zeitpunkts ($t$) gebildet wird, dass vorab ein Referenzwert ($I_{Medium}$) für den aufintegrierten Signalverlauf ($I_S(t)$) bei nur mit dem ersten Medium (14) befülltem Behälter (12) bestimmt wird und dass der Grenzübergang (18, 20) durch einen Vergleich des aufintegrierten Signalverlaufs ($I_S(t)$) mit dem Referenzwert ($I_{Medium}$) erkannt wird.

2. Verfahren nach Anspruch 1, wobei die Referenzposition ($t_0$) der Sondenanfang einer in dem Behälter (12) angeordneten Sonde (28) ist.

3. Verfahren nach Anspruch 1 oder 2, wobei die Signallaufzeit ($t$) aus Signallaufzeitintervallen summiert wird, die eine Verzögerung der Signalausbreitung an der zu einem jeweiligen Signallaufzeitintervall gehörigen Sondenposition einer in dem Behälter (12) angeordneten Sonde (28) durch eine Korrektur mit dem bis zu dieser jeweiligen Sondenposition aufintegrierten Signalverlauf ($I_S$) berücksichtigen.

4. Verfahren nach Anspruch 3, wobei in die Korrektur zusätzlich eine von der spezifischen Wellenausbreitung in dem Behälter (12) abhängige Umgebungskonstante eingeht.

5. Verfahren nach Anspruch 4, wobei die Umgebungskonstante in einer Kalibrationsmessung bei leerem Behälter (12) bestimmt wird, bei der ein Integral ($I_{end}$) des Signalverlaufs ($S$) über einen Bereich eines am Sondenende entstehenden Artefaktpulses gebildet wird.

6. Verfahren nach Anspruch 5, wobei für den Vergleich der Signalverlauf ($S$) ein zweites Mal aufintegriert wird, der zweiten Integration ($I_{Stop}$) jedoch anstelle des Signalverlaufs ($S$) selbst dessen Absolutbetrag ($|S|$) oder der punktweise quadrierte Signalverlauf ($S^2$) zugrunde gelegt wird.

7. Verfahren nach Anspruch 5, wobei der Grenzübergang (18, 20) in einem iterativen Verfahren erkannt wird, welches den Signalverlauf ($S$) in durch die Abtastrate des Signalverlaufs ($S$) vorgegebenen Schritten ab der Referenzposition ($t_0$) bis zu einem Abbruchkriterium aufintegriert, nämlich ob der bis zu dem jeweiligen Schritt ($i$) aufintegrierte Signalverlauf ($I_S$) oder ein entsprechendes Integral ($I_{Stop}$) des Absolutbetrags ($|S|$) des Signalverlaufs ($S$) oder des punktweise quadrierten Signalverlaufs ($S^2$) den Schwellwert ($K \cdot I_{Medium}$) überschreitet.

8. Verfahren nach Anspruch 7 und einem der Ansprüche 3 oder 4, wobei die Signallaufzeit ($t$) anfangs auf Null gesetzt und in jedem Schritt ($i$) um ein Inkrement

$(\dfrac{I_{end} + I_S}{I_{end} - I_S})$ erhöht wird, das sich als Quotient berechnet, dessen Zähler von der Summe ($I_{end}$ + $I_S$) aus der Umgebungskonstanten ($I_{end}$) und dem aufintegriertem Signalverlauf ($I_S$) und dessen Nenner von der Differenz ($I_{end}$ - $I_S$) aus der Umgebungskonstante ($I_{end}$) und dem aufintegriertem Signalverlauf ($I_S$) gebildet wird.

9. Verfahren nach einem der Ansprüche 5 bis 8, wobei der Referenzwert ($I_{Medium}$) als Schwellwertintegral des Signalverlaufs ($S$) im Bereich eines Echosignals (40) an dem Grenzübergang (18) zu dem ersten Medium (14) gebildet wird.

10. Verfahren nach Anspruch 9. wobei ein Schwellwert ($K \cdot I_{Medium}$) auf 90 % bis 110 % des Schwellwertintegrals ($I_{Medium}$) gesetzt wird, um den Grenzüberganz (18) zu dem ersten Medium (14) zu erkennen, und/oder wobei der Schwellwert ($K \cdot I_{Medium}$) auf 5% bis 30 % des Schwellwertintegrals ($I_{Medium}$) gesetzt wird, um den Grenzübergang (20) zu dem zweiten Medium (16) zu erkennen.

11. Verfahren nach einem der vorhergehenden Ansprüche, wobei der Grenzübergang (20) zu dem zweiten Medium (16) daran erkannt wird, dass der aufintegrierte Signalverlauf ($I_S$) sich ab dem Grenzübergang (20) systematisch von Null unterscheidet.

12. Verfahren nach einem der vorhergehenden Ansprüche, wobei der Signalverlauf ($S$), der aufintegrierte Signalverlauf ($I_S$) und/oder der Schwellwert ($K \cdot I_{Medium}$) um einen Driftkorrekturwert skaliert wird.

13. Verfahren nach einem der vorhergehenden Ansprüche, wobei der Signalverlauf ($S$) mit einer füllstandsabhängigen Amplitudenkennlinie reskaliert wird.

14. Sensor (10), insbesondere TDR-Füllstandssensor, mit einem Sender (32) und einem Empfänger (34) zum Aussenden und Empfangen eines elektromagnetischen Signals, insbesondere eines Mikrowellensignals sowie mit einer Steuerung (30), welche dafür ausgebildet ist, den Füllstand eines ersten Mediums (14) und/oder eines zweiten Mediums (16) in einem Behälter (12) anhand der Laufzeit des Signals zu bestimmen, **dadurch gekennzeichnet, dass** die Steuerung (30) dafür ausgebildet ist, den Füllstand mit einem Verfahren nach einem der vorhergehenden Ansprüche zu bestimmen.

**Claims**

1. A method for filling level measurement in a container (12) having a first medium (14) and at least one second medium (16) arranged thereabove, in particular a foam layer, wherein an electromagnetic signal is transmitted, in particular along a probe (28) arranged in the container (12), and a signal curve ($S$) of the signal reflected in the container (12) is recorded; wherein a signal time of flight (t) up to a border transition (18, 20) to the first medium (14) or up to the second medium (16) is determined with reference to the signal curve ($S$) and a filling level of the first medium (14) or a filling level of the second medium (16) is determined from the signal time of flight (t), **characterized in that** an integrated signal curve ($I_s(t)$), the integral starting from a reference position ($t_0$), is formed as a function of a respective point in time (t), **in that** initially a reference value ($I_{Medium}$) for the integrated signal curve ($I_S(t)$) is determined when the container (12) is filled with only the first medium (14), and **in that** the border transition (18, 20) is recognized by a comparison of the integral over the signal curve ($I_S(t)$) with the reference value ($I_{Medium}$).

2. The method in accordance with claim 1, wherein the reference position ($t_0$) is the probe start of a probe (28) arranged in the container (12).

3. The method in accordance with claim 1 or 2, wherein the signal time of flight (t) is summed up from signal time of flight intervals which take account of a delay in the signal propagation at the probe position belonging to a respective signal time of flight interval by a correction with the integral over the signal curve ($I_S$) integrated up to this respective probe position, the probe position being the probe position of a probe (28) arranged in the container (12).

4. The method in accordance with claim 3, wherein an environmental constant dependent on the specific wave propagation in the container (12) additionally enters into the correction.

5. The method in accordance with claim 4, wherein the environmental constant is determined in a calibration measurement with an empty container (12), in which measurement an integral ($I_{end}$) of the signal curve ($S$) is formed over a region of an artifact pulse arising at the probe end.

6. The method in accordance with claim 5, wherein the signal curve ($S$) is integrated for a second time for the comparison, but, instead of the signal curve ($S$) itself, its absolute amount ($|S|$) or the signal curve ($S^2$) squared point-wise is used as the basis for the second integration ($I_{Stop}$).

**7.** The method in accordance with claim 5, wherein the border transition (18, 20) is recognized in an iterative process which integrates the signal curve ($S$) in steps predefined by the sampling rate of the signal curve ($S$) from the reference position ($t_0$) onward up to an abort criterion, namely whether the signal curve ($I_S$) integrated up to the respective step ($i$) or a corresponding integral ($I_{Stop}$) of the absolute amount ($|S|$) of the signal curve ($S$) or of the signal curve ($S^2$) squared point-wise exceeds the threshold value ($K \cdot I_{Medium}$).

**8.** The method in accordance with claim 7 and any of claims 3 or 4, wherein initially the signal time of flight ($t$) is set to zero and in every step ($i$) is increased by an increment $(\dfrac{I_{end} + I_S}{I_{end} - I_S})$ which is calculated as a quotient whose numerator is formed from the sum ($I_{end}+I_S$) from the environmental constant ($I_{end}$) and the integral over the signal curve ($I_S$) and whose denominator is formed from the difference ($I_{end}-I_S$) from the environmental constant ($I_{end}$) and the integral over the signal curve ($I_S$).

**9.** The method in accordance with any of claims 5 to 8, wherein the reference value ($I_{Medium}$) is formed as a threshold value integral of the signal curve ($S$) in a region of an echo signal (40) at the border transition (18) to the first medium (14).

**10.** The method in accordance with claim 9, wherein a threshold value ($K \cdot I_{Medium}$) is set to 90% to 110% of the threshold value integral ($I_{Medium}$) to recognize the border transition (18) to the first medium (14) and/or wherein the threshold value ($K \cdot I_{Medium}$) is set to 5% to 30% of the threshold value integral ($I_{Medium}$) to recognize the border transition (20) to the second medium (16).

**11.** The method in accordance with any of the preceding claims, wherein the border transition (20) to the second medium (16) is recognized in that the integral over the signal curve ($I_S$) differs systematically from zero from the border transition (20) onward.

**12.** The method in accordance with any of the preceding claims, wherein the signal curve ($S$), the integral over the signal curve ($I_s$) and/or the threshold value ($K \cdot I_{Medium}$) is scaled by a drift correction value.

**13.** The method in accordance with any of the preceding claims, wherein the signal curve ($S$) is rescaled by an amplitude characteristic dependent on the filling level.

**14.** A sensor (10), in particular a TDR filling level sensor, having a transmitter (32) and a receiver (34) for transmitting and receiving an electromagnetic signal, in particular a microwave signal, as well as having a control (30) which is configured to determine the filling level of a medium (14) and/or of a second medium (16) in a container (12) with reference to the signal time of flight, **characterized in that** the control (30) is configured to determine the filling level using a method according to any of the preceding claims.

**Revendications**

**1.** Procédé pour la mesure du niveau de remplissage dans un récipient (12) avec un premier milieu (14) et au moins un second milieu (16) agencé au-dessus de celui-ci, en particulier une couche de mousse, dans lequel on émet un signal électromagnétique, en particulier le long d'une sonde (28) agencée dans le récipient (12), et on enregistre une évolution (S) du signal réfléchi dans le récipient (12), et on détermine, au moyen de l'évolution du signal (S), un temps de parcours du signal (t) jusqu'à une frontière (18, 20) vers le premier milieu (14) ou vers le second milieu (16), et on détermine, à partir du temps de parcours du signal (t), un niveau de remplissage du premier milieu (14) ou un niveau de remplissage du second milieu (16), **caractérisé en ce qu'**une évolution du signal ($I_s(t)$) intégrée à partir d'une position de référence ($t_0$) est formée à titre de fonction d'un instant respectivement considéré (t), **en ce que** l'on détermine au préalable une valeur de référence ($I_{milieu}$) pour l'évolution du signal intégré ($I_s(t)$) alors que le récipient (12) est rempli uniquement avec le premier milieu (14) et **en ce que** la frontière (18, 20) est reconnue par une comparaison de l'évolution du signal intégrée ($I_s(t)$) avec la valeur de référence ($I_{milieu}$).

**2.** Procédé selon la revendication 1, dans lequel la position de référence ($t_0$) est le début d'une sonde (28) agencée dans le récipient (12).

**3.** Procédé selon la revendication 1 ou 2, dans lequel le temps de parcours du signal (t) est obtenu en faisant la somme d'intervalles du temps de propagation du signal, qui tiennent compte d'un ralentissement de la propagation du signal à la position, appartenant à un intervalle respectif du temps de propagation du signal, d'une sonde (28) agencée dans le récipient (12), par une correction avec l'évolution du signal intégré (Is) jusqu'à cette position respective de la sonde.

**4.** Procédé selon la revendication 3, dans lequel on incorpore dans la correction additionnellement une constante environnementale dépendant de la propagation spécifique des ondes dans le récipient (12).

5. Procédé selon la revendication 4, dans lequel la constante environnementale est déterminée dans une mesure de calibrage alors que le récipient (12) est vide, mesure dans laquelle on forme une intégrale ($I_{end}$) de l'évolution du signal (S) sur une zone d'une impulsion d'artefact apparaissant à l'extrémité de la sonde.

6. Procédé selon la revendication 5, dans lequel pour la comparaison, on intègre une seconde fois l'évolution du signal (S) mais on utilise à la base de la seconde intégration ($I_{Stop}$), au lieu de l'évolution du signal (S) elle-même, sa valeur absolue (|S|) ou le carré de l'évolution du signal ($S^2$) point par point.

7. Procédé selon la revendication 5, dans lequel la frontière (18, 20) est reconnue dans une procédure itérative, laquelle intègre l'évolution du signal (S) dans des pas imposés par la cadence de palpage de l'évolution du signal (S) à partir de la position de référence ($t_0$) jusqu'à un critère de rupture, à savoir si l'évolution du signal ($I_s$) intégrée jusqu'au pas respectif (i) ou une intégrale correspondante ($I_{stop}$) de la valeur absolue (|S|) de l'évolution du signal (S) ou du carré de l'évolution du signal point par point ($S^2$) dépasse la valeur seuil ($K \cdot I_{milieu}$).

8. Procédé selon la revendication 7 et l'une des revendications 3 ou 4, dans lequel le temps de parcours du signal (t) est mis à zéro au départ et est augmenté à chaque pas (i) d'un incrément ($I_{end}+I_s$)/($I_{end}-I_s$), calculé sous forme de quotient dont le dividende est formé par la somme ($I_{end}+I_s$) de la constante environnementale ($I_{end}$) et de l'évolution du signal intégrée ($I_s$) et dont le diviseur est formé par la différence ($I_{end}-I_s$) de la constante environnementale ($I_{end}$) et de l'évolution du signal intégrée ($I_s$).

9. Procédé selon l'une des revendications 5 à 8, dans lequel la valeur de référence ($I_{milieu}$) est formée sous forme d'intégrale de valeur seuil de l'évolution du signal (S) dans la région d'un signal écho (40) au niveau de la frontière (18) vers le premier milieu (14).

10. Procédé selon la revendication 9, dans lequel on pose une valeur seuil ($K-I_{milieu}$) à 90 % à 110 % de l'intégrale de la valeur seuil ($I_{milieu}$), afin de reconnaître la frontière (18) vers le premier milieu (14), et/ou on pose la valeur seuil ($K \cdot I_{milieu}$) à 5 % à 30 % de l'intégrale de la valeur seuil ($I_{milieu}$) afin de reconnaître la frontière (20) vers le second milieu (16).

11. Procédé selon l'une des revendications précédentes, dans lequel la frontière (20) vers le second milieu (16) est reconnue en ce que l'évolution du signal intégrée ($I_s$) diffère systématiquement de zéro à partir de la frontière (20).

12. Procédé selon l'une des revendications précédentes, dans lequel l'évolution du signal (S), l'évolution du signal intégrée ($I_s$) et/ou la valeur seuil ($K-I_{milieu}$) sont mis à l'échelle au moyen d'une valeur de correction de dérive.

13. Procédé selon l'une des revendications précédentes, dans lequel l'évolution du signal (S) est remise à l'échelle avec une courbe caractéristique d'amplitude dépendant du niveau de remplissage.

14. Capteur (10), en particulier capteur de niveau de remplissage TDR, comprenant un émetteur (32) et un récepteur (34) pour émettre et recevoir un signal électromagnétique, en particulier un signal à microondes, et comprenant une commande (30) qui est réalisée pour déterminer le niveau de remplissage d'un premier milieu (14) et/ou d'un second milieu (16) dans un récipient (12) au moyen du temps de parcours du signal, **caractérisé en ce que** la commande est réalisée pour déterminer le niveau de remplissage avec un procédé selon l'une des revendications précédentes.

## Figur 1

## Figur 2

Figur 3

Figur 4

Figur 5

Figur 6

Figur 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2365302 A1
- DE 10051151 A1
- US 6724197 B2
- US 5723979 A
- US 6445192 B1
- DE 10196640 T1
- DE 10044888 A1
- DE 102012101725
- DE 102005063079 A1
- DE 10249544 A1